# EUROPÄISCHE PATENTSCHRIFT

(11) **EP 2 232 601 B1**
(45) Veröffentlichungstag und Bekanntmachung des Hinweises auf die Patenterteilung: **05.12.2012**
(21) Anmeldenummer: 08859401.5
(22) Anmeldetag: 24.10.2008
(51) Int. Cl.: H01L 41/26, H01L 41/193, C08G 18/08, C08G 18/10, C08G 18/12, C08G 18/28, C08G 18/40, C08G 18/42, C08G 18/44, C08G 18/48, C08G 18/72

(54) **ENERGIEWANDLER HERGESTELLT AUS FILMBILDENDEN WÄSSRIGEN POLYURETHAN-DISPERSIONEN**
ENERGY CONVERTER PRODUCED FROM FILM-FORMING AQUEOUS POLYURETHANE DISPERSIONS
CONVERTISSEUR D'ÉNERGIE COMPOSÉ DE DISPERSIONS FILMOGÈNES AQUEUSES DE POLYURÉTHANE

(30) Priorität: 12.12.2007 DE 102007059858
(43) Veröffentlichungstag der Anmeldung: 29.09.2010
(73) Patentinhaber: Bayer MaterialScience AG, 51368 Leverkusen (DE)
(72) Erfinder: JENNINGER, Werner, 50677 Köln (DE); DÖRR, Sebastian, 40597 Düsseldorf (DE); WAGNER, Joachim, 51061 Köln (DE); KÖHLER, Burkhard, 34289 Zierenberg (DE)
(86) Internationale Anmeldenummer: PCT/EP2008/009004
(87) Internationale Veröffentlichungsnummer: WO 2009/074192

(56) Entgegenhaltungen:
- WO-A-01/06575
- WO-A-2006/027544
- WO-A-2007/115697
- US-A- 5 977 685

## Beschreibung

Die vorliegende Erfindung betrifft Zusammensetzungen enthaltend wässrige Polymer-Dispersionen, insbesondere Polyurethan-Dispersionen, welche zur Herstellung von Energiewandlern eingesetzt werden und daraus hergestellte Energiewandler und die Anwendung derartiger Energiewandler.

Wandler wandeln elektrische Energie in mechanische Energie um und umgekehrt. Sie werden für Sensoren, Aktuatoren und Generatoren eingesetzt.

Der grundsätzliche Aufbau eines solchen Wandlers besteht aus einer Schicht des elektroaktiven Polymeren, welche beidseitig mit Elektroden beschichtet ist, wie beispielsweise in WO 01/06575 beschrieben. Dieser grundsätzliche Aufbau kann in unterschiedlichsten Konfigurationen zur Herstellung von Sensoren, Aktuatoren oder Generatoren eingesetzt werden.

Im Stand der Technik sind verschiedene Polymere als elektroaktive Schicht beschrieben, siehe beispielsweise in WO 01/06575 oder US 59 77685.

Polymerdispersionen zur Herstellung der elektroaktiven Schicht sind bislang nicht beschrieben.

Polymer-Dispersionen als Ausgangsbasis zur Herstellung von elastischen Filmen weisen verschiedene Vorteile auf, insbesondere sind sie durch die Abwesenheit von größeren Mengen an Lösemitteln sicher zu handhaben und lösen Kunststoffsubstate im allgemeinen nicht an. Eine Absaugung von Lösemitteln ist meist nicht erforderlich, weiterhin kann im Allgemeinen bei Temperaturen zwischen Raumtemperatur und 100°C gearbeitet werden, so dass auch temperaturempfindliche Substrate beschichtbar sind.

Aufgabe der vorliegenden Erfindung war daher die Bereitstellung von neuen elastischen isolierenden elektroaktiven Schichten für Aktuatoren, Sensoren und Generatoren, welche vorteilhafte Eigenschaften aufweisen. Insbesondere sollen sie eine einfache Verarbeitung ermöglichen und vorteilhafte mechanische Eigenschaften aufweisen.

Es wurde nun gefunden, dass filmbildende Zusammensetzungen auf Basis wässriger Polyurethan-Dispersionen sich gut zur Herstellung elastischen isolierenden Zwischenschichten für Aktuatoren eignen.

Gegenstand der vorliegenden Erfindung sind daher filmbildende Zusammensetzungen enthaltend wässrige Polyurethan-Dispersionen, zur Herstellung von Aktuatoren, Sensoren und Generatoren gemäß Anspruch 4.

Gegenstand der vorliegenden Erfindung ist weiterhin ein Verfahren zur Herstellung von Aktuatoren durch Einsatz eines Films, einer Folie oder einer Beschichtung hergestellt aus einer wässrigen Polyurethan-Dispersion.

Gegenstand der vorliegenden Erfindung sind weiterhin Aktuatoren hergestellt unter Einsatz eines Films aus einer wässrigen Polyurethan-Dispersion gemäß Ansprüch 1.

Gegenstand der vorliegenden Erfindung sind weiterhin elektronische und elektrische Geräte, Vorrichtungen, Apparate, Bausteine, Automaten, Komponenten und Instrumente gemäß Anspruch 5, die entsprechende Aktuatoren enthalten.

Prinzipiell können alle bekannten wässrigen Polyurethan-Dispersionen in den filmbildenden Zusammensetzungen eingesetzt werden. Bevorzugt sind jedoch anionisch hydrophilierte und anionische/nichtionisch hydrophilierte Polyurethan-Dispersionen.

Erfindungsgemäß einzusetzende Polyurethan-Dispersionen sind erhältlich, in dem
A) isocyanatfunktionelle Prepolymere aus
   A1) organischen Polyisocyanaten
   A2) polymeren Polyolen mit zahlenmittleren Molekulargewichten von 400 bis 8000 g/mol, vorzugsweise 400 bis 6000 g/mol und besonders bevorzugt von 600 bis 3000 g/mol, und OH-Funktionalitäten von 1,5 bis 6, bevorzugt 1,8 bis 3, besonders bevorzugt von 1,9 bis 2,1, und
   A3) gegebenenfalls hydroxyfunktionellen Verbindungen mit Molekulargewichten von 62 bis 399 g/mol sowie
   A4) gegebenenfalls isocyanatreaktiven, anionischen oder potentiell anionischen und/oder gegebenenfalls nichtionischen Hydrophilierungsmitteln,
   hergestellt, und
B) dessen freie NCO-Gruppen dann ganz oder teilweise
   B1) gegebenenfalls mit aminofunktionellen Verbindungen mit Molekulargewichten von 32 bis 400 g/mol und
   B2) mit aminofunktionellen, anionischen oder potentiell anionischen Hydrophilierungsmitteln
   unter Kettenverlängerung umgesetzt werden und die Prepolymere vor, während oder nach Schritt B) in Wasser dispergiert werden.

Entsprechend hergestellte Polyurethanschäume, die als Wundauflagen Verwendung finden, sind aus WO 07/115697 bekannt.

Isocyanatreaktive Gruppen sind beispielsweise primäre und sekundäre Aminogruppen, Hydroxygruppen oder Thiolgruppen.

Bevorzugt sind diese wässrigen Polyurethan-Dispersionen anionisch mittels Sulfonatgruppen und/oder Carboxylatgruppen hydrophiliert. Besonders bevorzugt sind zur anionischen Hydrophilierung ausschließlich Sulfonatgruppen enthalten.

Um eine gute Sedimentationsstabilität zu erreichen, liegt die zahlenmittlere Teilchengröße der speziellen Polyurethan-Dispersionen bevorzugt bei weniger als 750 nm, besonders bevorzugt bei weniger als 500 nm, bestimmt mittels Laserkorrelations-Spektroskopie.

Bevorzugt besitzen die Polyurethan-Dispersionen Feststoffgehalte von 10 bis 70 Gew.-%, besonders bevorzugt 30 bis 70 Gew.-%, ganz besonders bevorzugt 30 bis 65 Gew.-% bezogen auf das darin enthaltene Polyurethan.

Bevorzugt weisen diese Polyurethan-Dispersionen weniger als 5 Gew.-%, besonders bevorzugt weniger als 0,2 Gew.-%, bezogen auf die gesamte Dispersionen, an ungebundenen organischen Aminen auf.

Falls gewünscht, kann das Prepolymer vor, während oder nach der Dispergierung durch Beimischung einer Base ganz oder teilweise in die anionische Form überführt werden.

Um eine anionische Hydrophilierung zu erreichen müssen in A4) und/oder B2) Hydrophilierungsmittel eingesetzt werden, die wenigstens eine gegenüber NCO-Gruppen reaktive Gruppe wie Amino-, Hydroxy- oder Thiolgruppen aufweisen und darüber hinaus -COO⁻ oder -SO₃⁻ oder - PO₃²⁻ als anionische bzw. deren ganz oder teilweise protonierte Säureformen als potentiell anionische Gruppen aufweisen.

Bevorzugt werden in A4) und/oder B2) solche Verbindungen zur anionischen oder potentiell anionischen Hydrophilierung eingesetzt, die als anionische oder potentiell anionische Funktionalität ausschließlich Sulfonsäure- bzw. Sulfonatgruppen (-SO₃H bzw. -SO₃M, mit M = Alkali- oder Erdalkalimetall) aufweisen.

Geeignete Polyisocyanate der Komponente A1) sind die dem Fachmann an sich bekannten aliphatischen, aromatischen oder cycloaliphatischen Polyisocyanate einer NCO-Funktionalität von grö-βer oder gleich 2.

Beispiele solcher geeigneten Polyisocyanate sind 1,4-Butylendiisocyanat, 1,6-Hexamethylendiisocyanat (HDI), Isophorondiisocyanat (IPDI), 2,2,4- und/oder 2,4,4-Trimethylhexamethylendiisocyanat, die isomeren Bis-(4,4'-isocyanatocyclohexyl)methane oder deren Mischungen beliebigen Isomerengehalts, 1,4-Cyclohexylendiisocyanat, 4-Isocyanatomethyl-1,8-octandiisocyanat (Nonantriisocyanat), 1,4-Phenylendiisocyanat, 2,4- und/oder 2,6-Toluylendiisocyanat, 1,5-Naphthylendiisocyanat, 2,2'-und/oder 2,4'- und/oder 4,4'-Diphenylmethandiisocyanat, 1,3-und/oder 1,4-Bis-(2-isocyanato-prop-2-yl)-benzol (TMXDI), 1,3-Bis(isocyanato-methyl)benzol (XDI) sowie Alkyl-2,6-diisocyanatohexanoate (Lysindiisocyanate) mit C1-C8-Alkylgruppen.

Neben den vorstehend genannten Polyisocyanaten können auch modifizierte Diisocyanate die eine Funktionalität ≥2 aufweisen, mit Uretdion-, Isocyanurat-, Urethan-, Allophanat-, Biuret-, Iminooxadiazindion- oder Oxadiazintrionstruktur sowie Mischungen aus diesen anteilig eingesetzt werden.

Bevorzugt handelt es sich um Polyisocyanate oder Polyisocyanatgemische der vorstehend genannten Art mit ausschließlich aliphatisch oder cycloaliphatisch gebundenen Isocyanatgruppen oder Mischungen aus diesen und einer mittleren NCO-Funktionalität der Mischung von 2 bis 4, bevorzugt 2 bis 2,6 und besonders bevorzugt 2 bis 2,4.

Besonders bevorzugt werden in A1) Hexamethylendiisocyanat, Isophorondiisocyanat oder die isomeren Bis-(4,4'-isocyanatocyclohexyl)methane sowie Mischungen der vorgenannten Diisocyanate eingesetzt.

In A2) werden polymere Polyole mit einem zahlenmittleren Molekulargewicht Mₙ von 400 bis 8000 g/mol, bevorzugt von 400 bis 6000 g/mol und besonders bevorzugt von 600 bis 3000 g/mol eingesetzt. Diese weisen bevorzugt eine OH-Funktionalität von 1,5 bis 6, besonders bevorzugt von 1,8 bis 3, ganz besonders bevorzugt von 1,9 bis 2,1 auf.

Solche polymeren Polyole sind die in der Polyurethanlacktechnologie an sich bekannten Polyesterpolyole, Polyacrylatpolyole, Polyurethanpolyole, Polycarbonatpolyole, Polyetherpolyole, Polyesterpolyacrylatpolyole, Polyurethanpolyacrylatpolyole, Polyurethanpolyesterpolyole, Polyurethanpolyetherpolyole, Polyurethanpolycarbonatpolyole und Polyesterpolycarbonatpolyole. Diese können in A2) einzeln oder in beliebigen Mischungen untereinander eingesetzt werden.

Solche Polyesterpolyole sind die an sich bekannten Polykondensate aus Di- sowie gegebenenfalls Tri- und Tetraolen und Di- sowie gegebenenfalls Tri- und Tetracarbonsäuren oder Hydroxycarbonsäuren oder Lactonen. Anstelle der freien Polycarbonsäuren können auch die entsprechenden Polycarbonsäureanhydride oder entsprechende Polycarbonsäureester von niederen Alkoholen zur Herstellung der Polyester verwendet werden.

Beispiele für geeignete Diole sind Ethylenglykol, Butylenglykol, Diethylenglykol, Triethylenglykol, Polyalkylenglykole wie Polyethylenglykol, weiterhin 1,2-Propandiol, 1,3-Propandiol, Butandiol(1,3), Butandiol(1,4), Hexandiol(1,6) und Isomere, Neopentylglykol oder Hydroxypivalinsäureneopentylglykolester, wobei Hexandiol(1,6) und Isomere, Butandiol(1,4), Neopentylglykol und Hydroxypivalinsäureneopentylglykolester bevorzugt sind. Daneben können auch Polyole wie Trimethylolpropan, Glycerin, Erythrit, Pentaerythrit, Trimethylolbenzol oder Trishydroxyethylisocyanurat eingesetzt werden.

Als Dicarbonsäuren können Phthalsäure, Isophthalsäure, Terephthalsäure, Tetrahydrophthalsäure, Hexahydrophthalsäure, Cyclohexandicarbonsäure, Adipinsäure, Azelainsäure, Sebacinsäure, Glutarsäure, Tetrachlorphthalsäure, Maleinsäure, Fumarsäure, Itaconsäure, Malonsäure, Korksäure, 2-Methylbernsteinsäure, 3,3-Diethylglutarsäure und/oder 2,2-Dimethylbernsteinsäure eingesetzt werden. Als Säurequelle können auch die entsprechenden Anhydride verwendet werden.

Sofern die mittlere Funktionalität des zu veresternden Polyols > als 2 ist, können zusätzlich auch Monocarbonsäuren, wie Benzoesäure und Hexancarbonsäure mit verwendet werden.

Bevorzugte Säuren sind aliphatische oder aromatische Säuren der vorstehend genannten Art. Besonders bevorzugt sind Adipinsäure, Isophthalsäure und Phthalsäure.

Hydroxycarbonsäuren, die als Reaktionsteilnehmer bei der Herstellung eines Polyesterpolyols mit endständigen Hydroxylgruppen mitverwendet werden können, sind beispielsweise Hydroxycapronsäure, Hydroxybuttersäure, Hydroxydecansäure, Hydroxystearinsäure und dergleichen. Geeignete Lactone sind Caprolacton, Butyrolacton und Homologe. Bevorzugt ist Caprolacton.

Ebenfalls können in A2) hydroxylgruppenaufweisende Polycarbonate, bevorzugt Polycarbonatdiole, mit zahlenmittleren Molekulargewichten Mₙ von 400 bis 8000 g/mol, bevorzugt 600 bis 3000 g/mol eingesetzt werden. Diese sind durch Reaktion von Kohlensäurederivaten, wie Diphenylcarbonat, Dimethylcarbonat oder Phosgen, mit Polyolen, bevorzugt Diolen, erhältlich.

Beispiele derartiger Diole sind Ethylenglykol, 1,2- und 1,3-Propandiol, 1,3- und 1,4-Butandiol, 1,6-Hexandiol, 1,8-Octandiol, Neopentylglykol, 1,4-Bishydroxymethylcyclohexan, 2-Methyl-1,3-propandiol, 2,2,4-Trimethylpentandiol-1,3, Dipropylenglykol, Polypropylenglykole, Dibutylenglykol, Polybutylenglykole, Bisphenol A und lactonmodifizierte Diole der vorstehend genannten Art.

Bevorzugt enthält die Diolkomponente 40 bis 100 Gew.-% Hexandiol, bevorzugt sind 1,6-Hexandiol und/oder Hexandiolderivate. Solche Hexandiolderivate basieren auf Hexandiol und weisen neben endständigen OH-Gruppen Ester- oder Ethergruppen auf. Solche Derivate sind durch Reaktion von Hexandiol mit überschüssigem Caprolacton oder durch Veretherung von Hexandiol mit sich selbst zum Di- oder Trihexylenglykol erhältlich.

Statt oder zusätzlich zu reinen Polycarbonatdiolen können auch Polyether-Polycarbonatdiole in A2) eingesetzt werden.

Hydroxylgruppen aufweisende Polycarbonate sind bevorzugt linear gebaut.

Ebenfalls können in A2) Polyetherpolyole eingesetzt werden.

Geeignet sind beispielsweise die in der Polyurethanchemie an sich bekannten Polytetramethylenglykolpolyether wie sie durch Polymerisation von Tetrahydrofuran mittels kationischer Ringöffnung erhältlich sind.

Ebenfalls geeignete Polyetherpolyole sind die an sich bekannten Additionsprodukte von Styroloxid, Ethylenoxid, Propylenoxid, Butylenoxid und/oder Epichlorhydrin an di- oder polyfunktionelle Startermoleküle. Polyetherpolyole, basierend auf der zumindest anteiligen Addition von Ethylenoxid an di- oder polyfunktionelle Startermoleküle, können auch als Komponente A4) eingesetzt werden (nichtionische Hydrophilierungsmittel).

Als geeignete Startermoleküle können alle dem Stand der Technik nach bekannten Verbindungen eingesetzt werden, wie zum Beispiel Wasser, Butyldiglykol, Glycerin, Diethylenglykol, Trimethyolpropan, Propylenglykol, Sorbit, Ethylendiamin, Triethanolamin, 1,4-Butandiol.

Bevorzugte Komponenten in A2) sind Polytetramethylenglykolpolyether und Polycarbonat-Polyole bzw. deren Mischungen und besonders bevorzugt sind Polytetramethylenglykolpolyether.

In A3) können Polyole des genannten Molekulargewichtsbereichs mit bis zu 20 Kohlenstoffatomen, wie Ethylenglykol, Diethylenglykol, Triethylenglykol, 1,2-Propandiol, 1,3-Propandiol, 1,4-Butandiol, 1,3-Butylenglykol, Cyclohexandiol, 1,4-Cyclohexandimethanol, 1,6-Hexandiol, Neopentylglykol, Hydrochinondihydroxyethylether, Bisphenol A (2,2-Bis(4-hydroxyphenyl)propan), hydriertes Bisphenol A (2,2-Bis(4-hydroxycyclohexyl)propan), Trimethylolpropan, Trimethylolethan, Glycerin, Pentaerythrit sowie deren beliebige Mischungen untereinander eingesetzt werden.

Geeignet sind auch Esterdiole des genannten Molekulargewichtsbereichs wie α-Hydroxybutyl-ε-hydroxy-capronsäureester, ω-Hydroxyhexyl-y-hydroxybuttersäure-ester, Adipinsäure-(ß-hydroxyethyl)ester oder Terephthalsäurebis(ß-hydroxyethyl)-ester.

Ferner können in A3) auch monofunktionelle isocyanatreaktive Hydroxyl-gruppenhaltige Verbindungen eingesetzt werden. Beispiele solcher monofunktionellen Verbindungen sind Ethanol, n-Butanol, Ethylenglykolmonobutylether, Diethylenglykolmonomethylether, Diethylenglykolmonobutylether, Propylenglykolmonomethylether, Dipropylenglykol-monomethylether, Tripropylenglykolmonomethylether, Dipropylenglykolmono-propylether, Propylenglykolmonobutylether, Dipropylenglykolmonobutylether, Tripropylenglykolmonobutylether, 2-Ethylhexanol, 1-Octanol, 1-Dodecanol, 1-Hexadecanol.

Geeignete ionisch oder potentiell ionisch hydrophilierende Verbindungen entsprechend der Definition der Komponente A4) sind z.B. Mono- und Dihydroxycarbonsäuren, Mono- und Dihydroxysulfonsäuren, sowie Mono- und Dihydroxyphosphonsäuren und ihre Salze wie Dimethylolpropionsäure, Dimethylolbuttersäure, Hydroxypivalinsäure, Äpfelsäure, Zitronensäure, Glykolsäure, Milchsäure, das propoxylierte Addukt aus 2-Butendiol und NaHSO₃, z.B. beschrieben in der DE-A 2 446 440 (Seite 5-9, Formel I-III).

Geeignete nichtionisch hydrophilierende Verbindungen der Komponente A4) sind z.B. Polyoxyalkylenether, die mindestens eine Hydroxy-, Amino- oder Thiolgruppe enthalten. Beispiele sind die monohydroxyfunktionellen, im statistischen Mittel 5 bis 70, bevorzugt 7 bis 55 Ethylenoxideinheiten pro Molekül aufweisenden Polyalkylenoxidpolyetheralkohole, wie sie in an sich bekannter Weise durch Alkoxylierung geeigneter Startermoleküle zugänglich sind (z.B. in Ullmanns Encyclopädie der technischen Chemie, 4. Auflage, Band 19, Verlag Chemie, Weinheim S. 31-38). Diese sind entweder reine Polyethylenoxidether oder gemischte Polyalkylenoxidether, wobei sie mindestens 30 mol-%, bevorzugt mindestens 40 mol-% bezogen auf alle enthaltenen Alkylenoxideinheiten an Ethylenoxideinheiten enthalten.

Besonders bevorzugte nichtionische Verbindungen sind monofunktionelle gemischte Polyalkylenoxidpolyether, die 40 bis 100 mol-% Ethylenoxid- und 0 bis 60 mol-% Propylenoxideinheiten aufweisen.

Geeignete Startermoleküle für solche nichtionischen Hydrophilierungsmittel sind gesättigte Monoalkohole wie Methanol, Ethanol, n-Propanol, Isopropanol, n-Butanol, Isobutanol, sec-Butanol, die isomeren Pentanole, Hexanole, Octanole und Nonanole, n-Decanol, n-Dodecanol, n-Tetradecanol, n-Hexadecanol, n-Octadecanol, Cyclohexanol, die isomeren Methylcyclohexanole oder Hydroxymethylcyclohexan, 3-Ethyl-3-hydroxymethyloxetan oder Tetrahydrofurfurylalkohol, Diethylenglykol-monoalkylether, wie beispielsweise Diethylenglykolmonobutylether, ungesättigte Alkohole wie Allylalkohol, 1,1-Dimethylallylalkohol oder Oleinalkohol, aromatische Alkohole wie Phenol, die isomeren Kresole oder Methoxyphenole, araliphatische Alkohole wie Benzylalkohol, Anisalkohol oder Zimtalkohol, sekundäre Monoamine wie Dimethylamin, Diethylamin, Dipropylamin, Diisopropylamin, Dibutylamin, Bis-(2-ethylhexyl)-amin, N-Methyl- und N-Ethylcyclohexylamin oder Dicyclohexylamin sowie heterocyclische sekundäre Amine wie Morpholin, Pyrrolidin, Piperidin oder 1H-Pyrazol. Bevorzugte Startermoleküle sind gesättigte Monoalkohole der vorstehend genannten Art. Besonders bevorzugt werden Diethylenglykolmonobutylether oder n-Butanol als Startermoleküle verwendet.

Für die Alkoxylierungsreaktion geeignete Alkylenoxide sind insbesondere Ethylenoxid und Propylenoxid, die in beliebiger Reihenfolge oder auch im Gemisch bei der Alkoxylierungsreaktion eingesetzt werden können.

Als Komponente B1) können organische Di- oder Polyamine wie beispielsweise 1,2-Ethylendiamin, 1,2- und 1,3-Diaminopropan, 1,4-Diaminobutan, 1,6-Diaminohexan, Isophorondiamin, Isomerengemisch von 2,2,4- und 2,4,4-Trimethylhexamethylendiamin, 2-Methylpentamethylendiamin, Diethylentriamin, 4,4-Diaminodicyclohexylmethan, Hydrazinhydrat, und/oder Dimethylethylendiamin eingesetzt werden.

Darüber hinaus können als Komponente B1) auch Verbindungen, die neben einer primären Aminogruppe auch sekundäre Aminogruppen oder neben einer Aminogruppe (primär oder sekundär) auch OH-Gruppen aufweisen, eingesetzt werden. Beispiele hierfür sind primäre/sekundäre Amine, wie Diethanolamin, 3-Amino-1-methylaminopropan, 3-Amino-1-ethylaminopropan, 3-Amino-1-cyclohexylaminopropan, 3-Amino-1- methylaminobutan, Alkanolamine wie N-Aminoethylethanolamin, Ethanolamin, 3-Aminopropanol, Neopentanolamin.

Ferner können als Komponente B1) auch monofunktionelle isocyanatreaktive Aminverbindungen eingesetzt werden, wie beispielsweise Methylamin, Ethylamin, Propylamin, Butylamin, Octylamin, Laurylamin, Stearylamin, Isononyloxypropylamin, Dimethylamin, Diethylamin, Dipropylamin, Dibutylamin, N-Methylaminopropylamin, Diethyl(methyl)aminopropylamin, Morpholin, Piperidin, bzw. geeignete substituierte Derivate davon, Amidamine aus diprimären Aminen und Monocarbonsäuren, Monoketim von diprimären Aminen, primär/tertiäre Amine, wie N,N-Dimethylaminopropylamin.

Bevorzugt werden 1,2-Ethylendiamin, Bis(4-aminocyclohexyl)methan, 1,4-Diaminobutan, Isophorondiamin, Ethanolamin, Diethanolamin und Diethylentriamin eingesetzt.

Geeignete anionisch hydrophilierende Verbindungen der Komponente B2) sind Alkalimetallsalze der Mono- und Diaminosulfonsäuren. Beispiele solcher anionischen Hydrophilierungsmittel sind Salze der 2-(2-Aminoethylamino)ethansulfonsäure, Ethylendiamin-propyl- oder -butylsulfonsäure, 1,2- oder 1,3-Propylendiamin-β-ethylsulfonsäure oder Taurin. Weiterhin kann das Salz der Cyclohexylaminopropansulfonsäure (CAPS) aus WO-A 01/88006 als anionisches Hydrophilierungsmittel verwendet werden.

Besonders bevorzugte anionische Hydrophilierungsmittel B2) sind solche, die Sulfonatgruppen als ionische Gruppen und zwei Aminogruppen enthalten, wie die Salze der 2-(2-Aminoethylamino)ethylsulfonsäure und 1,3-Propylendiamin-β-ethylsulfonsäure.

Zur Hydrophilierung können auch Mischungen aus anionischen und nichtionischen Hydrophilierungsmitteln verwendet werden.

In einer bevorzugten Ausführungsform zur Herstellung der speziellen Polyurethan-Dispersionen werden die Komponenten A1) bis A4) und B1) bis B2) in den folgenden Mengen eingesetzt, wobei sich die Einzelmengen stets zu 100 Gew.-% addieren:
5 bis 40 Gew.-% Komponente A1),
55 bis 90 Gew.-% A2),
0,5 bis 20 Gew.-% Summe der Komponenten A3) und B1)
0,1 bis 25 Gew.-% Summe der Komponenten A4) und B2), wobei bezogen auf die Gesamtmengen der Komponenten A1) bis A4) und B1) bis B2) 0,1 bis 5 Gew.-% an anionischen bzw. potentiell anionischen Hydrophilierungsmitteln aus A4) und/oder B2) verwendet werden.

In einer besonders bevorzugten Ausführungsform zur Herstellung der speziellen Polyurethan-Dispersionen werden die Komponenten A1) bis A4) und B1) bis B2) in den folgenden Mengen eingesetzt, wobei sich die Einzelmengen stets zu 100 Gew.-% aufaddieren:
5 bis 35 Gew.-% Komponente A1),
60 bis 90 Gew.-% A2),
0,5 bis 15 Gew.-% Summe der Komponenten A3) und B1)
0,1 bis 15 Gew.-% Summe der Komponenten Komponente A4) und B2), wobei bezogen auf die Gesamtmengen der Komponenten A1) bis A4) und B1) bis B2) 0,2 bis 4 Gew.-% an anionischen bzw. potentiell anionischen Hydrophilierungsmitteln aus A4) und/oder B2) verwendet werden.

In einer ganz besonders bevorzugten Ausuhrungsform zur Herstellung der speziellen Polyurethan-Dispersionen werden die Komponenten A1) bis A4) und B1) bis B2) in den folgenden Mengen eingesetzt, wobei sich die Einzelmengen stets zu 100 Gew.-% aufaddieren:
10 bis 30 Gew.-% Komponente A1),
65 bis 85 Gew.-% A2),
0,5 bis 14 Gew.-% Summe der Komponenten A3) und B1)
0,1 bis 13,5 Gew.-% Summe der Komponenten A4) und B2), wobei bezogen auf die Gesamtmengen der Komponenten A1) bis A4) und B1) bis B2) 0,5 bis 3,0 Gew.-% an anionischen bzw. potentiell anionischen Hydrophilierungsmitteln aus A4) und/oder B2) verwendet werden.

Die Herstellung der Polyurethan-Dispersionen kann in einer oder mehreren Stufe/-n in homogener oder bei mehrstufiger Umsetzung, teilweise in disperser Phase durchgeführt werden. Nach vollständig oder teilweise durchgeführter Polyaddition aus A1) bis A4) erfolgt ein Dispergier-, Emulgier- oder Lösungsschritt. Im Anschluss erfolgt gegebenenfalls eine weitere Polyaddition oder Modifikation in disperser Phase.

Dabei können alle aus dem Stand der Technik bekannten Verfahren wie z. B. Prepolymer-Mischverfahren, Acetonverfahren oder Schmelzdispergierverfahren verwendet werden. Bevorzugt wird nach dem Aceton-Verfahren verfahren.

Für die Herstellung nach dem Aceton-Verfahren werden üblicherweise die Bestandteile A2) bis A4) und die Polyisocyanatkomponente A1) zur Herstellung eines isocyanatfunktionellen Polyurethan-Prepolymers ganz oder teilweise vorgelegt und gegebenenfalls mit einem mit Wasser mischbaren aber gegenüber Isocyanatgruppen inerten Lösungsmittel verdünnt und auf Temperaturen im Bereich von 50 bis 120°C aufgeheizt. Zur Beschleunigung der Isocyanatadditionsreaktion können die in der Polyurethan-Chemie bekannten Katalysatoren eingesetzt werden.

Geeignete Lösungsmittel sind die üblichen aliphatischen, ketofunktionellen Lösemittel wie Aceton, 2-Butanon, die nicht nur zu Beginn der Herstellung, sondern gegebenenfalls in Teilen auch später zugegeben werden können. Bevorzugt sind Aceton und 2-Butanon, besonders bevorzugt ist Aceton. Auch die Zugabe anderer Lösemittel ohne isocyanatreaktive Gruppen ist möglich, jedoch nicht bevorzugt.

Anschließend werden die gegebenenfalls zu Beginn der Reaktion noch nicht zugegebenen Bestandteile von A1) bis A4) zudosiert.

Bei der Herstellung des Polyurethan-Prepolymeren aus A1) bis A4) beträgt das Stoffmengenverhältnis von Isocyanat-Gruppen zu isocyanatreaktiven Gruppen im allgemeinen 1,05 bis 3,5, bevorzugt 1,1 bis 3,0, besonders bevorzugt 1,1 bis 2,5.

Die Umsetzung der Komponenten A1) bis A4) zum Prepolymer erfolgt teilweise oder vollständig, bevorzugt aber vollständig. Es werden so Polyurethan-Prepolymere, die freie Isocyanatgruppen enthalten, in Substanz oder in Lösung erhalten.

Im Anschluss wird in einem weiteren Verfahrensschritt, falls noch nicht oder nur teilweise geschehen, das erhaltene Prepolymer mit Hilfe von aliphatischen Ketonen wie Aceton oder 2-Butanon gelöst.

Die Umsetzung der Komponenten a1) bis a4) zum Prepolymer erfolgt teilweise oder vollständig, bevorzugt aber vollständig. Es werden so Polyurethan-Prepolymere, die freie Isocyanatgruppen enthalten, in Substanz oder in Lösung erhalten.

Im Neutralisationsschritt zur teilweisen oder vollständigen Überführung potentiell anionischer Gruppen in anionische Gruppen werden Basen wie tertiäre Amine, z.B. Trialkylamine mit 1 bis 12, bevorzugt 1 bis 6 C-Atomen in jedem Alkylrest oder Alkalimetallbasen wie die entsprechenden Hydroxide eingesetzt.

Beispiele hierfür sind Trimethylamin, Triethylamin, Methyldiethylamin, Tripropylamin, N-methylmorpholin, Methyldiisopropylamin, Ethyldiisopropylamin und Diisopropylethylamin. Die Alkylreste können beispielsweise auch Hydroxylgruppen tragen, wie bei den Dialkylmonoalkanol-, Alkyldialkanol- und Trialkanolaminen. Als Neutralisationsmittel sind gegebenenfalls auch anorganische Basen, wie wässrige Ammoniaklösung oder Natrium-, Lithium bzw. Kaliumhydroxid einsetzbar.

Bevorzugt sind Ammoniak, Triethylamin, Triethanolamin, Dimethylethanolamin oder Diisopropylethylamin sowie Natriumhydroxyd, Lithiumhydroxyd oder Kaliumhydroxid, besonders bevorzugt sind Ammoniak, Natriumhydroxyd, Lithiumhydroxyd oder Kaliumhydroxid .

Die Stoffmenge der Basen beträgt im allgemeinen 50 und 125 mol-%, bevorzugt zwischen 70 und 100 mol-% der Stoffmenge der zu neutralisierenden Säuregruppen. Die Neutralisation kann auch gleichzeitig mit der Dispergierung erfolgen, in dem das Dispergierwasser bereits das Neutralisationsmittel enthält.

Bei der Kettenverlängerung in Stufe B) werden NH₂- und/oder NH-funktionelle Komponenten mit den noch verbliebenen Isocyanatgruppen des Prepolymers umgesetzt. Bevorzugt wird die Kettenverlängerung/-terminierung vor der Dispergierung in Wasser durchgeführt.

Geeignete Komponenten zur Kettenverlängerung sind organische Di- oder Polyamine B1) wie beispielsweise Ethylendiamin, 1,2- und 1,3-Diaminopropan, 1,4-Diaminobutan, 1,6-Diaminohexan, Isophorondiamin, Isomerengemisch von 2,2,4- und 2,4,4-Trimethylhexamethylendiamin, 2-Methylpentamethylendiamin, Diethylentriamin, Diaminodicyclohexylmethan und/oder Dimethylethylendiamin.

Darüber hinaus können auch Verbindungen B1), die neben einer primären Aminogruppe auch sekundäre Aminogruppen oder neben einer Aminogruppe (primär oder sekundär) auch OH-Gruppen aufweisen, eingesetzt werden. Beispiele hierfür sind primäre/sekundäre Amine, wie Diethanolamin, 3-Amino-1-methylaminopropan, 3-Amino-1-ethylaminopropan, 3-Amino-1-cyclohexylamino-propan, 3-Amino-1- methylaminobutan, Alkanolamine wie N-Aminoethylethanolamin, Ethanolamin, 3-Aminopropanol, Neopentanolamin zur Kettenverlängerung bzw. -terminierung eingesetzt werden.

Zur Kettenterminierung werden üblicherweise Amine B1) mit einer gegenüber Isocyanaten reaktiven Gruppe wie Methylamin, Ethylamin, Propylamin, Butylamin, Octylamin, Laurylamin, Stearylamin, Isononyloxypropylamin, Dimethylamin, Diethylamin, Dipropylamin, Dibutylamin, N-Methylaminopropylamin, Diethyl(methyl)aminopropylamin, Morpholin, Piperidin, bzw. geeignete substituierte Derivate davon, Amidamine aus diprimären Aminen und Monocarbonsäuren, Monoketim von diprimären Aminen, primär/tertiäre Amine, wie N,N-Dimethylaminopropylamin verwendet.

Werden zur Kettenverlängerung anionische Hydrophilierungsmittel entsprechend der Definition B2) mit NH₂- oder NH-Gruppen eingesetzt, erfolgt die Kettenverlängerung der Prepolymere bevorzugt vor der Dispergierung.

Der Kettenverlängerungsgrad, also das Äquivalentverhältnis von NCO-reaktiven Gruppen der zur Kettenverlängerung und Kettenterminierung eingesetzten Verbindungen zu freien NCO-Gruppen des Prepolymers, liegt im allgemeinen zwischen 40 und 150 %, bevorzugt zwischen 50 und 120 %, besonders bevorzugt zwischen 60 und 120 %.

Die aminischen Komponenten B1) und B2), können gegebenenfalls in wasser- oder lösemittelverdünnter Form im erfindungsgemäßen Verfahren einzeln oder in Mischungen eingesetzt werden, wobei grundsätzlich jede Reihenfolge der Zugabe möglich ist.

Wenn Wasser oder organische Lösemittel als Verdünnungsmittel mit verwendet werden, so beträgt der Verdünnungsmittelgehalt in der in B) eingesetzten Komponente zur Kettenverlängerung bevorzugt 40 bis 95 Gew.-%.

Die Dispergierung erfolgt bevorzugt im Anschluss an die Kettenverlängerung. Dazu wird das gelöste und kettenverlängerte Polyurethanpolymer gegebenenfalls unter starker Scherung, wie z.B. starkem Rühren, entweder in das Dispergierwasser eingetragen oder es wird umgekehrt das Dispergierwasser zu den kettenverlängerte Polyurethanpolymerlösungen gerührt. Bevorzugt wird das Wasser in das gelöste kettenverlängerte Polyurethanpolymer gegeben.

Das in den Dispersionen nach dem Dispergierschritt noch enthaltene Lösemittel wird üblicherweise anschließend destillativ entfernt. Eine Entfernung bereits während der Dispergierung ist ebenfalls möglich.

Der Restgehalt an organischen Lösemitteln in den Polyurethan-Dispersionen beträgt typischerweise weniger als 10 Gew.-%, bevorzugt weniger als 3 Gew.-%, bezogen auf die gesamte Dispersion.

Der pH-Wert der erfindungswesentlichen Polyurethan-Dispersionen beträgt typischerweise weniger als 8,0, bevorzugt weniger als 7,5 und liegt besonders bevorzugt zwischen 5,5 und 7,5.

Typischerweise enthalten die erfindungsgemäßen filmbildenden Zusammensetzungen mindestens 10 Gew.-% Polyurethan, bezogen auf den Feststoffanteil aller in der Zusammensetzung enthaltenen filmbildenden Polymere. Bevorzugt sind jedoch mindestens 50 Gew.-%, besonders bevorzugt mindestens 90 Gew.-%, und ganz besonders bevorzugt mindestens 95 Gew.-% Polyurethan als filmbildendes Polymer enthalten.

Wird nicht ausschließlich Polyurethan als filmbildendes Polymer eingesetzt, so können weiterhin andere Polymer-Dispersionen mit eingesetzt werden, z.B. auf Basis von Polyestern, Poly(meth)acrylaten, Polyepoxiden, Polyvinylacetaten, Polyethylen, Polystyrol, Polybutadienen, Polyvinylchlorid und/oder entsprechenden Copolymerisaten.

Die filmbildenden Zusammensetzungen können neben den Polymer-Dispersionen zusätzlich auch Hilfs- und Zusatzstoffe enthalten. Beispiele für solche Hilfs- und Zusatzstoffe sind Vernetzer, Verdicker, Colösemittel, Thixotropiermittel, Stabilisatoren, Antioxidantien, Lichtschutzmittel, Emulgatoren, Tenside, Weichmacher, Pigmente, Füllstoffe und Verlaufshilfsmittel.

Im Sinne der vorliegenden Erfindung bewirken gegebenenfalls eingesetzte Vernetzer die Bildung kovalenter Bindungen zwischen den eingesetzten filmbildenden Polymeren, insbesondere Polyurethanen, womit z.B. die mechanischen Eigenschaften verbessert werden können. Geeignete Vernetzer sind beispielsweise blockierte oder unblockierte Polyisocyanat-Vernetzer, Amid- und Amin-Formaldehydharze, Phenolharze, Aldehyd- und Ketonharze, wie z.B. Phenol-Formaldehydharze, Resole, Furanharze, Harnstoffharze, Carbamidsäureesterharze, Triazinharze, Melaminharze, Benzoguanaminharze, Cyanamidharze oder Anilinharze. Bevorzugt sind Melamin-Formaldehyd Harze, wobei bis 20 mol-% des Melamins durch äquivalente Mengen Harnstoff ersetzt sein können. Besonders bevorzugt ist methyloliertes Melamin, z.B. Bi-Tri- und/oder Tetramethyolmelamin. Als Beispiel sei die Vernetzung Hydroxy-funktioneller Polyurethane mittels Isocyanat-funktioneller Bausteine genannt. Bevorzugt werden der Polymer-Dispersion erst kurz vor der Filmbildung solche Vernetzer, wie z.B. hydrophile Polyisocyanate (beschrieben in der EP-A-0 540 985), zugesetzt. Die Applikation erfolgt dann vorzugsweise zweikomponentig, z.B. mittels Zweikomponenten-Sprühauftrag. Bevorzugt werden die Polyurethan-Dispersionen jedoch ohne Vernetzer in die erfindungsgemäße Zusammensetzung eingesetzt.

Die filmbildenden Zusammensetzungen können neben den Polymer-Dispersionen zusätzlich auch Füllstoffe enthalten, die die Dielektrizitätskonstante des Films regulieren. Bevorzugt ist der Zusatz von speziellen Füllstoffen zur Erhöhung der Dielektrizitätskonstanten wie elektrisch leitfähige Füllstoffe oder Füllstoffe mit einer hohen Dielektrizitätskonstanten. Beispiele sind Ruß, Graphit, einwandige oder mehrwandige Kohlenstoff-Nanoröhrchen.

Additive zur Erhöhung der Dielektrizitätskonstante und/oder der Durchschlagsfeldstärke können auch nach Verfilmung noch zugesetzt werden, beispielsweise durch Erzeugung einer oder mehrerer weiteren Schicht(en) oder zur Durchdringung des Films.

Der Auftrag der erfindungsgemäßen filmbildenden Zusammensetzungen kann nach allen an sich bekannten Applikationsformen erfolgen, genannt seien beispielsweise Rakeln, Streichen, Gießen oder Sprühen.

Ein mehrschichtiger Auftrag mit gegebenenfalls zwischengelagerten Trocknungsschritten ist grundsätzlich auch möglich.

Für eine schnellere Trocknung und Fixierung der Schäume werden bevorzugt Temperaturen oberhalb von 30°C benutzt. Bevorzugt werden Temperaturen zwischen 30 und 200°C. Sinnvoll ist auch eine zwei- oder mehrstufige Trocknung, mit entsprechend ansteigendem Temperaturgradienten, um eine Aufkochung der Beschichtung zu verhindern. Die Trocknung erfolgt in der Regel unter Verwendung von an sich bekannten Heiz- und Trockenapparaten, wie (Umluft-) Trockenschränken, Heißluft oder IR-Strahlern. Auch die Trocknung durch Führen des beschichteten Substrates über geheizte Oberflächen, z.B. Walzen, ist möglich. Der Auftrag sowie die Trocknung können jeweils diskontinuierlich oder kontinuierlich durchgeführt werden, bevorzugt ist jedoch ein gänzlich kontinuierliches Verfahren.

Der erfindungsgemäßen Film kann mit weiteren Schichten versehen werden. Dies kann einseitig oder beidseitig geschehen, in einer Schicht oder in mehreren Schichten übereinander, durch vollständige oder durch flächig partielle Beschichtung des Films.

Als Trägermaterialien für die Filmherstellung eignen sich insbesondere Glas, Trennpapier, Folien und Kunststoffe, von denen der Film ggf. wieder einfach entfernt werden kann.

Die Verarbeitung der einzelnen Schichten erfolgt durch Gießen oder händisches bzw. maschinell durchgeführtes Rakeln; auch Drucken, Siebdrucken und Spritzen bzw. Sprühen und Tauchen sind mögliche Verabeitungstechniken. Generell sind alle Techniken denkbar, die bei einer Auftragung von dünnen Schichten - z.B. bei einer Lackierungen - eingesetzt werden können, denkbar.

Die Filme aus den Polymer-Dispersionen weisen eine gute mechanische Festigkeit und hohe Elastizität auf. Typischerweise sind die Werte für die maximale Spannung (Zugfestigkeit) größer als 0,2 N/mm² (0,2 MPa) und die maximale Dehnung (Bruchdehnung) ist größer als 250 %. Bevorzugt ist die maximale Spannung (Zugfestigkeit) zwischen 0,4 und 50 MPa und die Dehnung größer als 350 %. Das Elastizitätzmodul bei einer Dehnung von 100% liegt bevorzugt zwischen 0,1 und 10 MPa besonders bevorzugt zwischen 0,5 und 5 MPa (Bestimmung nach DIN 53455).

Die Filme haben nach dem Trocknen typischerweise eine Dicke von 0,1 bis 1500 µm, bevorzugt 1 bis 500 µm, besonders bevorzugt 5 bis 200 µm, ganz besonders bevorzugt 5 bis 50 µm.

Zum Aufbau eines Energiewandlers werden diese Filme (das sind die elektroaktiven Polymerschichten) beidseitig mit Elektroden beschichtet, wie beispielsweise in WO 01/06575 beschrieben. Dieser grundsätzliche Aufbau kann in unterschiedlichsten Konfigurationen zur Herstellung von Sensoren, Aktuatoren oder Generatoren eingesetzt werden.

### Beispiele

Sofern nicht abweichend gekennzeichnet, beziehen sich alle Prozentangaben auf das Gewicht.

Sofern nicht abweichend vermerkt, beziehen alle analytischen Messungen auf Temperaturen von 23°C.

Die Bestimmung der Festkörpergehalte erfolgte nach DIN-EN ISO 3251.

NCO-Gehalte wurden, wenn nicht ausdrücklich anders erwähnt, volumetrisch gemäß DIN-EN ISO 11909 bestimmt.

Die Kontrolle auf freie NCO-Gruppen wurde mittels IR-Spektroskopie (Bande bei 2260 cm⁻¹) durchgeführt.

Die angegebenen Viskositäten wurden mittels Rotationsviskosimetrie nach DIN 53019 bei 23°C mit einem Rotationsviskosimeter der Firma Anton Paar Germany GmbH, Ostfildern, DE bestimmt.

Die Bestimmung der mittleren Teilchengrößen (angegeben ist das Zahlenmittel) der Polyurethan-Dispersionen erfolgte mittels Laserkorrelations-Spektroskopie (Gerät: Malvern Zetasizer 1000, Malver Inst. Limited).

Die Einarbeitung von Füllstoffen in die erfindungsgemäßen Dispersionen geschah mit einem Speedmixer (Modell 150 FV der Fa. Hauschild & Co KG, Postfach 4380, D-59039 Hamm).

Messungen der Filmschichtdicken wurden mit einem mechanischen Taster der Firma Heidenhain GmbH, Postfach 1260, D-83292 Traunreut, durchgeführt. Die Probekörper wurden an drei unterschiedlichen Stellen vermessen und der Mittelwert als repräsentativer Messwert benutzt.

Die Zugversuche wurden mittels einer Zugmaschine der Firma Zwick, Modell Nummer 1455, ausgestattet mit einer Kraftmessdose des Gesamtmessbereiches 1kN nach DIN 53455 mit einer Zuggeschwindigkeit von 50 mm/min ausgeführt. Als Probekörper wurden S2-Zugstäbe eingesetzt. Jede Messung wurde an drei gleichartig präparierten Probekörpern ausgeführt und der Mittelwert der erhaltenen Daten zur Bewertung verwendet. Speziell hierfür wurden neben der Zugfestigkeit ZF in [Mpa] und der Bruchdehnung BD in [%] noch die Spannung SP in [Mpa] bei 100% (=SP100) und 200% (=SP200) Dehnung bestimmt.

Die Bestimmung des elektrischen Volumen-Widerstandes VW wurde mit einem Messaufbau der Firma Keithley Instruments Inc., 28775 Aurora Road, Cleveland, Ohio 44139, phone: (440) 248-0400, (Elektrometer : Modell-Nummer 6517A; Messkopf : Modell-Nummer 8009) und einem mitgelieferten Programm (Modell-Nummer 6524 : High Resistance Measurement Software) durchgeführt. Es wurde eine symmetrische, rechteckörmige Spannung von +/- 50 V für die Dauer von 4 min pro Periode für die Dauer von 10 Perioden angelegt und der Stromfluß bestimmt. Aus den Werten für den Stromfluß kurz vor Umschalten der Spannung wurde der Widerstand des Prüfkörpers bei jeder Periode der Spannung berechnet und gegen die Periodenanzahl aufgetragen. Der Endwert dieser Auftragung gibt den Messwert für den elektrischen Volumen-Widerstand der Probe an.

Messungen der Dielektrizitätskonstante DK wurden mit einem Messaufbau der Firma Novocontrol Technologies GmbH & Co. KG, 56414 Hundsangen (Messbrücke : Alpha-A Analyzer, Messkopf: ZGS Active Sample Cell Test Interface) mit einem Durchmesser der Probekörper von 20 mm ausgeführt. Untersucht wurde dabei ein Frequenzbereich von 10⁷ bis 10⁻² Hz. Als Maß für die Dielektrizitätskonstante des untersuchten Materials wurde der Realteil der Dielektrizitätskonstante bei 10⁻² Hz gewählt.

### Verwendete Substanzen und Abkürzungen:

| | |
|---|---|
| Diaminosulfonat: | NH₂-CH₂CH₂-NH-CH₂CH₂-SO₃Na (45 %ig in Wasser) |
| Desmophen^{®} 2020/C2200: | Polycarbonatpolyol, OH-Zahl 56 mg KOH/g, zahlenmittleres Molekulargewicht 2000 g/mol (Bayer MaterialScience AG, Leverkusen, DE) |
| PolyTHF^{®} 2000: | Polytetramethylenglykolpolyol, OH-Zahl 56 mg KOH/g, zahlenmittleres Molekulargewicht 2000 g/mol (BASF AG, Ludwigshafen, DE) |
| PolyTHF^{®} 1000: | Polytetramethylenglykolpolyol, OH-Zahl 112 mg KOH/g, zahlenmittleres zahlenmittleres Molekulargewicht 1000 g/mol (BASF AG, Ludwigshafen, DE) |
| Polyether LB 25: | monofunktioneller Polyether auf Ethylenoxid-/Propylenoxidbasis zahlenmittleres Molekulargewicht 2250 g/mol, OH-Zahl 25 mg KOH/g (Bayer MaterialScience AG, Leverkusen, DE) |
| Printex 140 | Produkt der Degussa GmbH, 60311 Frankfurt am Main, Mittlere Korngröße 29 nm, BET-Oberfläche 90 m²/g, pH-Wert 4,5 (alle Angaben hierzu lt. Datenblatt Degussa) |

### Beispiel 1: Polyurethan-Dispersion 1

987,0 g PolyTHF^{®} 2000, 375,4 g PolyTHF^{®} 1000, 761,3 g Desmophen^{®} C2200 und 44,3 g Polyether LB 25 wurden in einer Standard-Rührapparatur auf 70°C aufgeheizt. Anschließend wurde bei 70°C innerhalb von 5 min ein Gemisch aus 237,0 g Hexamethylendiisocyanat und 313,2 g Isophorondiisocyanat zugegeben und bei 120°C gerührt, bis der theoretische NCO-Wert erreicht war. Das fertige Prepolymer wurde mit 4830 g Aceton gelöst und dabei auf 50°C abgekühlt und anschlie-βend wurde eine Lösung aus 25,1 g Ethylendiamin, 116,5 g Isophorondiamin, 61,7 g Diaminosulfonat und 1030 g Wasser innerhalb von 10 min zudosiert. Die Nachrührzeit betrug 10 min. Dann wurde durch Zugabe von 1250 g Wasser dispergiert. Es folgte die Entfernung des Lösemittels durch Destillation im Vakuum.

Die erhaltene weiße Dispersion hatte nachfolgenden Eigenschaften:

| | |
|---|---|
| Feststoffgehalt: | 61% |
| Partikelgröße (LKS): | 312 nm |
| Viskosität (Viskosimeter, 23°C): | 241 mPas |
| pH (23°C): | 6,02 |
| pH (23°C): | 7,15 |

### Beispiel 2: Polyurethan-Dispersion 7

450 g PolyTHF^{®} 1000 und 2100 g PolyTHF^{®} 2000 wurden auf 70°C aufgeheizt. Anschließend wurde bei 70°C innerhalb von 5 min ein Gemisch aus 225,8 g Hexamethylendiisocyanat und 298,4 g Isophorondiisocyanat zugegeben und solange bei 100-115°C gerührt bis der theoretische NCO-Wert unterschritten war. Das fertige Prepolymer wurde mit 5460 g Aceton bei 50°C gelöst und anschließend eine Lösung aus 29,5 g Ethylendiamin, 143,2 g Diaminosulfonat und 610 g Wasser innerhalb von 10 min zudosiert. Die Nachrührzeit betrug 15 min. Danach wurde innerhalb von 10 min durch Zugabe von 1880 g Wasser dispergiert. Es folgte die Entfernung des Lösemittels durch Destillation im Vakuum und es wurde eine lagerstabile Dispersion erhalten.

| | |
|---|---|
| Feststoffgehalt: | 56 % |
| Partikelgröße (LKS): | 276 nm |
| Viskosität: | 1000 mPas |

### Beispiel 3: Polyurethan-Dispersion

1649,0 g eines Polyesters aus Adipinsäure, Hexandiol und Neopentylglykol mit einem mittleren Molekulargewicht von 1700 g/mol wurden auf 65°C aufgeheizt. Anschließend wurden bei 70°C innerhalb von 5 min 291,7 g Hexamethylendiisocyanat zugegeben und solange bei 100-115°C gerührt bis der theoretische NCO-Wert unterschritten war. Das fertige Prepolymer wurde mit 3450 g Aceton bei 50°C gelöst und anschließend eine Lösung aus 16,8 g Ethylendiamin, 109,7 g Diaminosulfonat und 425 g Wasser innerhalb von 3 min zudosiert. Die Nachrührzeit betrug 15 min. Danach wurde innerhalb von 10 min durch Zugabe von 1880 g Wasser dispergiert. Es folgte die Entfernung des Lösemittels durch Destillation im Vakuum und es wurde eine lagerstabile Dispersion erhalten.

| | |
|---|---|
| Feststoffgehalt: | 42 % |
| Partikelgröße (LKS): | 168 nm |
| Viskosität: | 425 mPas |
| pH-Wert: | 7,07 |

### Beispiel 4 : PUR-Dispersion

82,5 g PolyTI1F^{®} 1000, 308 g PolyTHF^{®} 2000 und 10,0 g 2-Ethylhexanol wurden auf 70°C aufgeheizt. Anschließend wurde bei 70°C innerhalb von 5 min ein Gemisch aus 41,4 g Hexamethylendiisocyanat und 54,7g Isophorondiisocyanat zugegeben und solange bei 110-125°C gerührt bis der theoretische NCO-Wert unterschritten war. Das fertige Prepolymer wurde mit 880 g Aceton bei 50°C gelöst und anschließend eine Lösung aus 3,8 g Ethylendiamin, 4,6 g Isophorondiamin, 26,3 g Diaminosulfonat und 138 g Wasser innerhalb von 10 min zudosiert. Die Nachrührzeit betrug 15 min. Danach wurde innerhalb von 10 min durch Zugabe von 364 g Wasser dispergiert. Es folgte die Entfernung des Lösemittels durch Destillation im Vakuum und es wurde eine lagerstabile Dispersion erhalten.

| | |
|---|---|
| Partikelgröße (LKS): | 181 nm |
| Viskosität: | 1300 mPas |

### Anwendungstechnische Versuche:

### Beispiel 5 (erfindungsgemäß):

Die eingesetzten Rohstoffe wurden nicht separat entgast. Die benötigte Menge von 100g an erfindungsgemäßer Dispersion lt. Beispiel 2 wurde in einem PP-Becher eingewogen. Aus dem noch flüssigen Reaktionsgemisch werden auf Glasplatten von Hand Filme der Nassschichtdicke 1 mm gerakelt. Alle Filme werden nach der Herstellung bei 30°C im Trockenschrank über Nacht getrocknet und anschließend 5 min bei 120°C nachgetempert. Die Filme können nach dem Tempern von Hand einfach von der Glasplatte gelöst werden.

### Beispiel 6 (erfindungsgemäß):

Die eingesetzten Rohstoffe wurden nicht separat entgast. Die benötigte Menge von 100g an erfindungsgemäßer Dispersion lt. Beispiel 2 wurde in einem PP-Becher eingewogen, die entsprechende Menge von 1,783 g an Printex 140 zugewogen und dann im 5 min bei 3000 U/min gemischt. Aus dem noch flüssigen Reaktionsgemisch werden auf Glasplatten von Hand Filme der Nassschichtdicke 1 mm gerakelt. Alle Filme werden nach der Herstellung bei 30°C im Trockenschrank über Nacht getrocknet und anschließend 5 min bei 120°C nachgetempert. Die Filme können nach dem Tempern von Hand einfach von der Glasplatte gelöst werden.

### Beispiel 7 (erfindungsgemäß):

Die eingesetzten Rohstoffe wurden nicht separat entgast. Die benötigte Menge von 100g an erfindungsgemäßer Dispersion lt. Beispiel 4 wurde in einem PP-Becher eingewogen. Aus dem noch flüssigen Reaktionsgemisch werden auf Glasplatten von Hand Filme der Nassschichtdicke 1 mm gerakelt. Alle Filme werden nach der Herstellung bei 30°C im Trockenschrank über Nacht getrocknet und anschließend 5 min bei 120°C nachgetempert. Die Filme können nach dem Tempern von Hand einfach von der Glasplatte gelöst werden.

### Beispiel 8 (Vergleichsbeispiel):

Alle flüssigen Rohstoffe wurden in einem dreistufigen Verfahren sorgfältig unter Argon entgast. 10g Terathane 650 (INVISTA GmbH, D-65795 Hatterheim, Poly-THF der Molmasse Mn = 650) wird in einem 60 ml Einweg-Mischbehälter (APM-Technika AG, Best. Nr. 1033152) eingewogen. Anschließend wird 0,005 g Dibutylzinndilaurat (Metacure® T-12, Air Products and Chemicals, Inc.) und 6,06 g des Isocyanates N3300 (das Isocyanurattrimere des HDI; Produkt der Bayer MaterialScience AG) dazu gewogen und 1 min bei 3000 Upm im Speedmixer vermischt. Das Reaktionprodukt wird auf eine Glasplatte gegossen und mit einem Rakel der Nassschichtdicke 1 mm zu einem homogenen Film ausgezogen. Der Film wird anschließend 16 h bei 80°C getempert.

### Beispiel 9 (Vergleichsbeispiel):

Alle flüssigen Rohstoffe wurden in einem dreistufigen Verfahren sorgfältig unter Argon entgast, der Ruß wurde über ein 125µm Sieb gesiebt. 10g Terathane 650 (INVISTA GmbH, D-65795 Hatterheim, Poly-THF der Molmasse Mn = 650) wird mit 0,536 g Printex 140, in einem 60 ml Einweg-Mischbehälter (APM-Technika AG, Best. Nr. 1033152) eingewogen und im Speedmixer (Produkt der Fa. APM-Technika AG, CH-9435 Heerbrugg; Vertrieb D: Hauschild; Typ DAC 150 FVZ) 3 min bei 3000 Upm zu einer homogenen Paste vermischt. Anschließend wird 0,005 g Dibutylzinndilaurat (Metacure® T-12, Air Products and Chemicals, Inc.) und 6,06 g des Isocyanates N3300 (das Isocyanurattrimere des HDI; Produkt der Bayer MaterialScience AG) dazu gewogen und 1 min bei 3000 Upm im Speedmixer vermischt. Die Reaktionspaste wird auf eine Glasplatte gegossen und mit einem Rakel der Nassschichtdicke 1 mm zu einem homogenen Film des Feststoffgehaltes 2% ausgezogen. Der Film wird anschließend 16 h bei 80°C getempert.

### Daten der Filme:

| Filme | BD | ZF | SP100 | SP200 | VW | DK |
|---|---|---|---|---|---|---|
| | [%] | [MPa] | [MPa] | [MPa] | [Ohm cm] | |
| Bsp. 5 * | 620 | 26,6 | 2,2 | 2,7 | 7,3*10¹⁰ | 125 |
| Bsp. 6 * | 625 | 38,9 | 2,6 | 3,3 | 3,6*10¹⁰ | 657 |
| Bsp. 7 * | 1432 | 3,4 | 0,46 | 0,58 | 4,8*10¹¹ | 26,9 |
| Bsp. 8 | 44 | 1,7 | - | - | 2,3*10¹¹ | 18,3 |
| Bsp.9 | 46 | 1,6 | - | - | 7,9*10¹¹ | 550 |

| | | | | | | |
|---|---|---|---|---|---|---|
| *: erfindungsgemäß | | | | | | |

Es zeigte sich bei den Versuchen, dass Filme aus Polyurethandispersionen deutliche Vorteile gegenüber dem Stand der Technik bieten.

Besonders vorteilhaft bei Einsatz der erfindungsgemäßen Filme aus Dispersionen sind die hohe Dielektrizitätskonstante und die sehr guten mechanische Eigenschaften wie: hohe Elastizität, hohe Reißdehnung, gut geeigneter Spannungs-Dehnungs-Verlauf mit niedriger Spannung bei moderaten Dehnungen im Gebrauchsbereich der Anwendung. Ziel war eine Bruchdehnung (BD) von mindestens 250%, bevorzugt 350%, besonders bevorzugt 400%, eine Zugfestigkeit (ZF) zwischen 0,2 und 100 MPa, bevorzugt zwischen 0,4 und 50 MPa, zusätzlich eine sehr flache Spannungs-Dehnungskurve mit Spannungen unter 10 MPa, bevorzugt zwischen 0,1 und 10 MPa bei moderaten Dehnungen im Bereich um 100% bis 200%, ein elektrischer Volumen-Widerstandes (VW) von mehr als 1*10¹⁰ Ohm cm und eine Dielektrizitätskonstante (DK) von mindestens 20. Bei den Vergleichsbeispielen war eine Spannung bei 100% bzw. 200% nicht messbar, da diese Materialien bereits bei 40 % bis 60% reissen.

Weiterhin vorteilhaft an der Verwendung der Dispersionen ist die einfache Handhabung, da es sich hierbei um ein niederviskoses 1K-System handelt, es ist keine Handhabung reaktiver Gruppen wie z.B. freier Isocyanate beim Einarbeiten der Füllstoffe erforderlich.

## Patentansprüche

1. Wandler zur Umwandlung von elektrischer Energie in mechanische Energie oder von mechanischer Energie in elektrische Energie, mindestens aufweisend zwei Elektroden und einen zwischen den Elektroden angeordneten Polymerfilm, **dadurch gekennzeichnet, dass** der Polymerfilm durch Trocknen einer wässrigen Polyurethandispersion hergestelit ist, die aus einem Prepolymerisationsverfahren mit folgenden Schritten stammt:
A) Herstellen von isocyanatfunktionellen Prepolymere aus
A1) organischen Polyisocyanaten,
A2) polymeren Polyolen mit einem Molekulargewicht (Zahlenmittel) von 400 bis 8000 g/mol und einer OH-Funktionalität von 1,5 bis 6 und
A3) gegebenenfalls hydroxyfunktionellen Verbindungen mit Molekulargewichten von 62 bis 399 g/mol und
A4) gegebenenfalls isocyanatreaktiven, anionischen oder potentiell anionischen und gegebenenfalls nichtlonischen Hydrophilierungsmitteln,
B) ganz oder teilweises Umsetzen der freien NCO-Gruppen des Prepolymeren aus A)
B1) gegebenenfalls mit aminofunktionellen Verbindungen mit Molekulargewichten von 32 bis 400 g/mol und
B2) mit aminofunktionellen, anionischen oder potentiell anionischen Hydrophilierungsmitteln,
wobei die Prepolymere vor, während oder nach Schritt B) in Wasser dispergiert werden.

2. Wandler nach Anspruch 1, **dadurch gekennzeichnet, dass** die Komponente A2) Polyetherpolyole enthält, bevozugt Polytetramethylenglykolpolyether.

3. Wandler nach Anspruch 1 oder 2, **dadurch gekennzeichnet, dass** die Komponente A1) difunktionelle Isocyanatbausteine enthält, bevorzugt difunktionelle aliphatische Isocyanatbausteine, besonders bevorzugt Hexamethylendiisocyanat und/oder Isophorondiisocyanat, und ganz besonders bevorzugt eine Mischung aus Hexamethylendiisocyanat und Isophorondiisocyanat.

4. Aktuator, Sensor oder Generator aufweisend wenigstens einen Wandler gemäß einem der Ansprüche 1 bis 3.

5. Vorrichtungen, insbesondere elektronische und elektrische Geräte, die wenigstens einen Aktuator, Sensor oder Generator gemäß Anspruch 4 enthalten.

## Claims

1. Transducer for conversion of electrical energy to mechanical energy or of mechanical energy to electrical energy, having at least two electrodes and a polymer film arranged between the electrodes, **characterized in that** the polymer film has been produced by drying an aqueous polyurethane dispersion which originates from a prepolymerization process having the following steps:
A) preparing isocyanate-functional prepolymers from
A1) organic polyisocyanates,
A2) polymeric polyols having a molecular weight (number average) of 400 to 8000 g/mol and an OH functionality of 1.5 to 6 and
A3) optionally hydroxy-functional compounds having molecular weights of 62 to 399 g/mol and
A4) optionally isocyanate-reactive, anionic or potentially anionic and optionally nonionic hydrophilizing agents,
B) fully or partly reacting the free NCO groups of the prepolymer from A)
B1) optionally with amino-functional compounds having molecular weights of 32 to 400 g/mol and
B2) with amino-functional, anionic or potentially anionic hydrophilizing agents,
with dispersion of the prepolymers in water before, during or after step B).

2. Transducer according to Claim 1, **characterized in that** component A2) comprises polyether polyols, preferably polytetramethylene glycol polyether.

3. Transducer according to Claim 1 or 2, **characterized in that** component A1) comprises difunctional isocyanate units, preferably difunctional aliphatic isocyanate units, more preferably hexamethylene diisocyanate and/or isophorone diisocyanate, and most preferably a mixture of hexamethylene diisocyanate and isophorone diisocyanate.

4. Actuator, sensor or generator comprising at least one transducer according to any of Claims 1 to 3.

5. Devices, especially electronic and electrical appliances, comprising at least one actuator, sensor or generator according to Claim 4.

## Revendications

1. Convertisseur pour la conversion d'énergie électrique en énergie mécanique ou d'énergie mécanique en énergie électrique, comprenant au moins deux électrodes et un film polymère agencé entre les électrodes, **caractérisé en ce que** le film polymère est fabriqué par séchage d'une dispersion aqueuse de polyuréthane, qui est issue d'un procédé de prépolymérisation comprenant les étapes suivantes :
A) la fabrication de prépolymères à fonction isocyanate à partir de
A1) des polyisocyanates organiques,
A2) des polyols polymères ayant un poids moléculaire (moyenne en nombre) de 400 à 8 000 g/mol et une fonctionnalité OH de 1,5 à 6, et
A3) éventuellement des composés à fonction hydroxy ayant des poids moléculaires de 62 à 399 g/mol, et
A4) éventuellement des agents d'hydrophilisation réactifs avec les isocyanates, anioniques ou potentiellement anioniques et éventuellement non ioniques,
B) la réaction totale ou partielle des groupes NCO libres du prépolymère de A)
B1) éventuellement avec des composés à fonction amino ayant des poids moléculaires de 32 à 400 g/mol, et
B2) avec des agents d'hydrophilisation à fonction amino, anioniques ou potentiellement anioniques,
les prépolymères étant dispersés dans de l'eau avant, pendant ou après l'étape B).

2. Convertisseur selon la revendication 1, **caractérisé en ce que** le composant A2) contient des polyéther polyols, de préférence des polytétraméthylène glycol polyéthers.

3. Convertisseur selon la revendication 1 ou 2, **caractérisé en ce que** le composant A1) contient des constituants isocyanate bifonctionnels, de préférence des constituants isocyanate aliphatiques bifonctionnels, de manière particulièrement préférée du diisocyanate d'hexaméthylène et/ou du diisocyanate d'isophorone, et de manière tout particulièrement préférée un mélange de diisocyanate d'hexaméthylène et de diisocyanate d'isophorone.

4. Actionneur, capteur ou générateur comprenant au moins un convertisseur selon l'une quelconque des revendications 1 à 3.

5. Dispositifs, notamment appareils électroniques et électriques, qui contiennent au moins un actionneur, capteur ou générateur selon la revendication 4.
